(19) Europäisches Patentamt
European Patent Office
Office européen des brevets

(11) **EP 3 571 772 B1**

(12) **EUROPEAN PATENT SPECIFICATION**

(45) Date of publication and mention
of the grant of the patent:
**27.12.2023 Bulletin 2023/52**

(21) Application number: **17765420.9**

(22) Date of filing: **08.09.2017**

(51) International Patent Classification (IPC):
**H03M 13/27** (2006.01)   **H03M 13/11** (2006.01)
**H03M 13/25** (2006.01)   **H03M 13/35** (2006.01)
**H04L 1/00** (2006.01)

(52) Cooperative Patent Classification (CPC):
**H03M 13/356; H03M 13/116; H03M 13/255;
H03M 13/271; H03M 13/6306; H03M 13/6393;
H04L 1/00**

(86) International application number:
**PCT/EP2017/072643**

(87) International publication number:
**WO 2019/048057 (14.03.2019 Gazette 2019/11)**

(54) **COLUMN-ROW INTERLEAVING FOR BIT INTERLEAVED CODED MODULATION**

SPALTEN-ZEILEN VERSCHACHTELUNG FÜR BIT VERSCHACHTELTE KODIERTE MODULATION

ENTRELACEMENT EN COLONNE ET EN RANGÉE POUR LA MODULATION CODÉE ENTRELACÉE PAR BITS

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**27.11.2019 Bulletin 2019/48**

(73) Proprietor: **Huawei Technologies Co., Ltd.
Longgang District
Shenzhen, Guangdong 518129 (CN)**

(72) Inventors:
• **ROBERT SAFAVI, Anahid
164 40 Kista (SE)**
• **PEROTTI, Alberto Giuseppe
164 40 Kista (SE)**
• **POPOVIC, Branislav, M
164 40 Kista (SE)**

(74) Representative: **Körber, Martin Hans et al
Mitscherlich PartmbB
Patent- und Rechtsanwälte
Karlstraße 7
80333 München (DE)**

(56) References cited:
**US-A1- 2003 081 690**

• **MEDIATEK INC: "On design of bit-level interleaver", 3GPP DRAFT; R1-1713710_ON DESIGN OF BIT_LEVEL INTERLEAVER V3_FINAL, 3RD GENERATION PARTNERSHIP PROJECT (3GPP) , vol. RAN WG1, no. Prague, Czech; 20170821 - 20170825 20 August 2017 (2017-08-20), XP051316509, Retrieved from the Internet: URL:http://www.3gpp.org/ftp/Meetings_3GPP_ SYNC/RAN1/Docs/ [retrieved on 2017-08-20]**
• **"Text proposal for SMP (Symbol Mapping based on bit Priority)", TSG-RAN WORKING GROUP 1 MEETING, XX, XX, 8 January 2002 (2002-01-08), pages 1-6, XP002227069,**
• **SAMSUNG: "Bit-level interleaver of LDPC codes on high order modulation", 3GPP DRAFT; R1-1714589_BIT-LEVEL INTERLEAVER OF LDPC CODES ON HIGH ORDER MODULATION_FINAL, 3RD GENERATION PARTNERSHIP PROJECT (3GPP) , vol. RAN WG1, no. Prague, Czechia; 20170821 - 20170825 26 August 2017 (2017-08-26), XP051328161, Retrieved from the Internet: URL:http://www.3gpp.org/ftp/tsg_ran/WG1_RL 1/TSGR1_90/Docs/ [retrieved on 2017-08-26]**

- QUALCOMM INCORPORATED: "LDPC Rate Matching", 3GPP DRAFT; R1-1711212_LDPC RATE_MATCHING, 3RD GENERATION PARTNERSHIP PROJECT (3GPP) , vol. RAN WG1, no. Qingdao, China; 20170627 - 20170630 26 June 2017 (2017-06-26), XP051300411, Retrieved from the Internet: URL:http://www.3gpp.org/ftp/Meetings_3GPP_SYNC/RAN1/Docs/ [retrieved on 2017-06-26]
- SAFAVI ANAHID R ET AL: "Ultra Low Density Spread Transmission", IEEE COMMUNICATIONS LETTERS, IEEE SERVICE CENTER, PISCATAWAY, NJ, US, vol. 20, no. 7, 1 July 2016 (2016-07-01), pages 1373-1376, XP011616351, ISSN: 1089-7798, DOI: 10.1109/LCOMM.2016.2564379 [retrieved on 2016-07-08]
- Zaidi Ali ET AL: "ERICSSON TECHNOLOGY 5G NEW RADIO: DESIGNING FOR THE FUTURE * 5G NR PHYSICAL LAYER DESIGN 2 ERICSSON TECH NOLOGY REVIEW * J U N E 27, 2017", ERICSSON TECHNOLOGY REVIEW ARTICLES, 24 July 2017 (2017-07-24), XP055780903, Retrieved from the Internet: URL:https://www.ericsson.com/49e9d0/assets /local/reports-papers/ericsson-technology-review/docs/2017/designing-for-the-future---the-5g-nr-physical-layer.pdf>

## Description

### Technical Field

The invention relates to a transmitting device and a receiving device. Furthermore, the invention also relates to corresponding methods and a computer program.

### Background

Bit-interleaved low density parity check (LDPC) coded modulation represents one of the most commonly used transmission schemes for wireless communications capable of operating very close to the system capacity. Some international standards including IEEE and 3GPP, under new radio (NR), adopted LDPC codes with adaptive modulations of order up to 256QAM to achieve very high spectral efficiencies.

NR LDPC codes are quasi-cyclic (QC) LDPC codes of length $n$, and dimension k < $n$. These codes are specified as the null space of a $k \times (n + 2Z)$ binary systematic parity-check matrix (PCM) H where the first 2Z systematic codeword bits are punctured. The binary PCM H is generated in the following way:

- Selected a base-graph matrix $\mathbf{H}_{BG}$ according to the criteria specified in NR specification among two possible base matrices $\mathbf{H}_{BG,1}$ and $\mathbf{H}_{BG,2}$, depending on the codeword length $n$ and dimension $k$;
- Lift $\mathbf{H}_{BG}$ by a lifting size Z, where Z is determined based on the codeword length $n$ and dimension $k$, to obtain $\mathbf{H}$.

Lifting consists in the following steps: the matrix $\mathbf{H}$ is obtained by replacing each element of $\mathbf{H}_{BG}$ with a $Z \times Z$ matrix, according to the following:

- Each element of value 0 in $\mathbf{H}_{BG}$ is replaced by an all zero matrix $\mathbf{0}$ of size $Z \times Z$;
- Each element of value 1 in $\mathbf{H}_{BG}$ is replaced by a circular permutation matrix $\mathbf{I}(P_{i,j})$ of size $Z \times Z$, where $i$ and $j$ are the row and column indices of the element, and $\mathbf{I}(P_{i,j})$ is obtained by circularly shifting the identity matrix $\mathbf{I}$ of size $Z \times Z$ to the right $P_{i,j}$ times. The value of $P_{i,j}$ is given by $P_{i,j} = mod(V_{i,j}, Z)$. The value of $V_{i,j}$ is given by the set index $i_{LS}$ and the selected base matrix.

The NR LDPC encoder maps the information vector i = $(i_1, ..., i_k)$ of size $k$ to a vector $\mathbf{d} = (d_1, ..., d_{n+2Z})$ as

$$\mathbf{d} = \mathbf{iG} \qquad\qquad (1)$$

where $\mathbf{G}$ is a binary matrix of size k $\times$ $n$, called generator matrix. In case of systematic codes, the generator matrix has the following structure:

$$\mathbf{G} = [\mathbf{I}_k \quad \mathbf{P}] \qquad\qquad (2)$$

where $\mathbf{I}_k$ is a $k \times k$ identity matrix and P is a $k \times (n - k)$ matrix. When the generator matrix is in systematic form, as in (2), a parity check matrix can be easily obtained as

$$\mathbf{H}_S = [\mathbf{P}^T \quad \mathbf{I}_{n-k}] \qquad\qquad (3)$$

where $\mathbf{P}^T$ denotes the transpose of P. It is worth noting that any matrix H that satisfies the following condition:

$$\mathbf{GH}^T = \mathbf{0} \qquad\qquad (4)$$

where 0 is an all-zero vector with $(n - k)$ elements, can be used as a parity check matrix for the code generated by $\mathbf{G}$. Therefore, any full-rank matrix obtained from linear combinations of the rows of $\mathbf{H}_S$ is a parity-check matrix for the code generated by $\mathbf{G}$. The parity-check matrices specified in NR are not in systematic form (3).

The NR LDPC codeword vector $\mathbf{c} = (c_1, ..., c_n)$ is obtained by puncturing the first 2Z systematic bits from vector $\mathbf{d}$. Therefore, the codeword vector $\mathbf{c}$ has the following structure: $\mathbf{c} = (i_{2Z+1}, i_{2Z+2}, ..., i_k, w_1, ..., w_{n-k+2Z})$, where $\mathbf{w} = (w_1, ...,$

$$H \times \begin{bmatrix} \mathbf{i}^{\mathrm{T}} \\ \mathbf{w}^{\mathrm{T}} \end{bmatrix} = \mathbf{0}$$

$w_{n-k+2Z}$) are parity-check bits obtained such that . Thus, the NR LDPC code is not systematic. However, its codewords contain a large subset of the information bits that enter the LDPC encoder. LDPC codes are typically decoded using low-complexity iterative algorithms that perform belief-propagation (BP) on a bipartite graph whose adjacency matrix is the PCM of the LDPC code.

Modulation symbols are drawn from a constellation $\chi_l = \{s_1^{(l)}, \ldots, s_{M_l}^{(l)}\}$ belonging to a set of available constellations $X = \{\chi_1, \ldots, \chi_L\}$. Each constellation $\chi_l$, $l = 1, \ldots, L$, is characterized by a *size* $M_l = |\chi_l|$ and an order $m_l = \log_2 M_l$. A labelling $\mathcal{L}(\chi_l)$ associates to each constellation symbol of $\chi_l$ a distinct binary vector of $m_l$ bits. For ease of notation, the constellation index is hereinafter dropped and reused again when needed. Each bit in the binary label of constellation $\chi$ is characterized by a bit-level capacity, conventionally defined as the mutual information of each bit in the constellation's binary label, measured when constellation symbols are transmitted on a certain channel, e.g. the AWGN channel. In particular, in a conventional bit-interleaved coded modulation (BICM) scheme, at the transmitter each m-tuple $(e_1, \ldots, e_m)$ of coded bits is mapped to a constellation symbol $s \in \chi$ which is then transmitted. At the receiver, a detector computes log-likelihood ratios (LLRs) of the transmitted bits as

$$\lambda_k = \log \frac{P(e_k = 1|y)}{P(e_k = 0|y)} = \log \frac{\sum_{s \in \chi : \mathcal{L}_k(s)=1} P(s|y)}{\sum_{s \in \chi : \mathcal{L}_k(s)=0} P(s|y)} \qquad (5)$$

for $k = 1, \ldots, m$, where $P(\varepsilon)$ indicates the probability that event $\varepsilon$ occurs, $y$ is the received signal and $\mathcal{L}_k(s)$ indicates the $k$th bit of the label associated to constellation symbol s. The bit-level capacity is defined as

$$\beta_k = I(e_k; \lambda_k) \qquad (6)$$

where $I(a; b)$ indicates the mutual information of symbols $a$ and $b$. If, for example, the channel is AWGN, the bit-level capacity can be estimated as

$$\beta_k = m - \mathbb{E}_{s,y}\Big[\log(1 + e^{\lambda_k}) - \mathcal{L}_k(s)\lambda_k\Big] \qquad (7)$$

where m is the constellation order and $\mathbb{E}_{s,y}[.]$ denotes the expectation operator.

For most channels of practical interest, including the AWGN channel, bit-level capacities are monotone non-decreasing functions $\beta_k$, $k = 1, \ldots, m$ of the SNR $\rho$ experienced on the channel. MEDIATEK INC, "On design of bit-level interleaver", vol. RAN WG1, no. Prague, Czech; 20170820, 3GPP draft, proposes a bit-level interleaving design in which the interleaver writes the data row by row and reads the data column by column. "Text proposal for SMP (Symbol Mapping based on bit Priority)", TSG-RAN WORKING GROUP 1 MEETING, 20020108, proposes a SMP interleaver. SAMSUNG, "Bit-level interleaver of LDPC codes on high order modulation", vol. RAN WG1, no. Prague, Czechia; 20170826, 3GPP draft, proposes a bit-level interleaver of LDPC codes. QUALCOMM INCORPORATED, "LDPC Rate Matching", vol. RAN WG1, no. Qingdao, China; 20170626, 3GPP DRAFT, proposes an interleaving and mapping method for LDPC encoding. US 2003/081690 A1 proposes a data transmitting/receiving method in a code devision multple access (CDMA) mobile communicaiton system.

It is known as well in the art the documents

SAFAVI ANAHID R ET AL: "Ultra Low Density Spread Transmission",IEEE vol. 20, no. 7, 1 July 2016 (2016-07-01), pages 1373-1376, XP011616351, ISSN: 1089-7798, DOI: 10.1109/ LCOMM.2016.2564379 [retrieved on 2016-07-08]

Zaidi Ali ET AL: "ERICSSON TECHNOLOGY 5G NEW RADIO: DESIGNING FOR THE FUTURE * 5G NR PHYSICAL LAYER DESIGN 2 ERICSSON TECH NOLOGY REVIEW * J U N E 27, 2017",ERICSSON TECHNOLOGY REVIEW ARTICLES, 24 July 2017 (2017-07-24), XP055780903.

## Summary

An objective of implementation forms of the invention is to provide a solution which mitigates or solves the drawbacks and problems of conventional solutions.

The above and further objectives are solved by the subject matter of the independent claims. Further advantageous embodiments of the present invention can be found in the dependent claims.

According to a first aspect of the invention, the above mentioned and other objectives are achieved with a transmitting device according to claim 1 for a communication system.

A transmitting device according to the first aspect provides a number of advantages over conventional solutions. An advantage of the transmitting device is to provide improved performance in respect of error rate compared to conventional solutions, i.e. lower error rate for any given signal-to-noise ratio (SNR) or equivalent quality measure. This is due to the fact that the coded transmissions are more reliable by using the transmitting device according to the first aspect. This is especially the case for low-density parity-check code (LDCP) coded transmissions with high order modulation.

The initial transmission is performed when a new information message is transmitted to the receiving device.

The re-transmission occurs when the initial transmission was unsuccessful and/or the receiving device indicates to the transmitting device that it did not successfully decode the information message. This may e.g. relate to re-transmission schemes, such as HARQ, etc. The re-transmission is performed after the initial transmission.

In an implementation form of a transmitting device according to the first aspect, the transmitting is further configured to, in an initial transmission,
circularly shift each row of the matrix so as to obtain a re-arranged row for each row of the matrix, wherein all systematic bits of a row of the matrix are arranged in the left-most positions of a re-arranged row and all parity-check bits of the row of the matrix are arranged in the right-most positions of the re-arranged row, wherein bits in the left-most positions of the re-arranged row are mapped to modulation label positions of the modulation constellation with a first reliability and bits in the right-most positions of the re-arranged row are mapped to modulation label positions of the modulation constellation with a second reliability.

An advantage with this implementation form is that circular shift permutations are simple to implement as the interleaver output can be generated by simply sequentially reading the bits in their input, starting from a certain position, and wrapping around to first input bit when the last input bit is reached.

In an implementation form of a transmitting device according to the first aspect, the transmitting is further configured to, in a re-transmission,
circularly shift each row of the matrix so as to obtain a re-arranged row for each row of the matrix, wherein systematic bits of a row of the matrix are arranged in the right-most positions of a re-arranged row and parity-check bits of the row of the matrix are arranged in the left-most positions of the re-arranged row, wherein bits in the left-most positions of the re-arranged row are mapped to modulation label positions of the modulation constellation with a second reliability and bits in the right-most positions of the re-arranged row are mapped to modulation label positions of the modulation constellation with a first reliability.

An advantage with this implementation form is that circular shift permutations are simple to implement as the interleaver output can be generated by simply sequentially reading the bits in their input, starting from a certain position, and wrapping around to first input bit when the last input bit is reached. Moreover, arranging parity-check bits in the most reliable modulation bit label positions helps the decoder to increase the coding gain, thereby resulting in a better error protection for the transmitted information message.

In an implementation form of a transmitting device according to the first aspect, the transmitting is further configured to

map each re-arranged row onto a modulation symbol of the modulation constellation so as to obtain a plurality of modulation symbols;
transmit the plurality of modulation symbols in a communication signal to the receiving device.

An advantage with this implementation form is that each re-arranged row already has the same size as the modulation label. Therefore, it is simple (low complex) to perform a one-to-one mapping of the re-arranged rows to modulation symbols.

In an implementation form of a transmitting device according to the first aspect, the transmitting is further configured to, in an initial transmission,

select all systematic bits of each row of the matrix so as obtain a first sub-row for each row of the matrix, wherein a first sub-row comprises all systematic bits of a row of the matrix, wherein bits in the first sub-row are mapped to modulation label positions of the modulation constellation with a first reliability;

select all parity-check bits of each row of the matrix so as obtain a second sub-row for each row of the matrix, wherein a second sub-row comprises all parity-check bits of a row of the matrix, wherein bits in the second sub-row are mapped to modulation label positions of the modulation constellation with a second reliability.

This implementation form is capable of grouping the systematics bits in the most reliable modulation label positions and the parity-check bits in the less reliable modulation label positions even when the information bits (and thus also the parity-check bits) are arranged non-contiguously in a row.

In an implementation form of a transmitting device according to the first aspect, the transmitting is further configured to, in a re-transmission,

select parity-check bits of each row of the matrix so as obtain a first sub-row for each row of the matrix, wherein a first sub-row comprises the parity-check bits of a row of the matrix, wherein bits in the first sub-row are mapped to modulation label positions of the modulation constellation with a second reliability;

select systematic bits of each row of the matrix so as obtain a second sub-row for each row of the matrix, wherein a second sub-row comprises the systematic bits of a row of the matrix, wherein bits in the second sub-row are mapped to modulation label positions of the modulation constellation with a first reliability.

This implementation form is capable of grouping the systematics bits in the most reliable modulation label positions and the parity-check bits in the less reliable modulation label positions even when the information bits (and thus also the parity-check bits) are arranged non-contiguously in a row.

In an implementation form of a transmitting device according to the first aspect, the transmitting is further configured to

combine the first sub-row and the second sub-row of each row in the matrix so as to obtain a combined row for each row of the matrix;

map each combined row to a modulation symbol of the modulation constellation so as to obtain a plurality of modulation symbols;

transmit the plurality of modulation symbols in a communication signal to the receiving device.

An advantage with this implementation form is that each combined row already has the same size as the modulation label, therefore it is simple (low complex) to perform a one-to-one mapping of the combined rows to modulation symbols.

In an implementation form of a transmitting device according to the first aspect, the transmitting is further configured to

determine a control message, wherein the control message comprises an indication of a number of information bits of the information message, a number of encoded bits of the codeword, and a modulation order of the modulation symbol;

transmit the control message to the receiving device.

An advantage with this implementation form is that the control message informs the receiving device about the interleaving operations thereby making easier for the receiving device to deinterleave.

In an implementation form of a transmitting device according to the first aspect, the modulation constellation is a quadrature amplitude modulation constellation.

An advantage with this implementation form is that quadrature amplitude modulations are simple to implement and very widely used modulations which exhibit multiple reliability levels, thereby potentially provide good performance when used with the transmitting device according to the first aspect.

In an implementation form of a transmitting device according to the first aspect, the codeword belongs to a low-density parity-check code book.

According to a second aspect of the invention, the above mentioned and other objectives are achieved with a receiving device according to claim 11 for a wireless communication system.

A receiving device according to the second aspect provides a number of advantages over conventional solutions. An advantage of the receiving device is to provide improved performance in respect of error rate compared to conventional solutions, i.e. lower error rate for any given signal-to-noise ratio (SNR) or equivalent quality measure. This is due to the fact that the coded transmissions are more reliable by using the transmitting device according to the first aspect. This is especially the case for low-density parity-check code (LDCP) coded transmissions with high order modulation.

In an implementation form of a receiving device according to the second aspect, the receiving device is further configured to

decode the de-rate matched soft codeword so as to obtain a codeword.

An advantage with this implementation form is that decoding corrects the errors in the de-rate-matched codeword thereby delivering at its output a more reliable message.

In an implementation form of a receiving device according to the second aspect, the receiving device is further configured to

obtain a control message, wherein the control message comprises an indication of a number of information bits of the information message, a number of encoded bits of the codeword, and a modulation order of the modulation symbol;

deinterleave the plurality of soft labels based on the control message.

An advantage with this implementation form is that by obtaining the control message, the receiving device is informed about the interleaving operations performed by the transmitting device thereby making easier for the receiving device to deinterleave.

According to a third aspect of the invention, the above mentioned and other objectives are achieved with a method according to claim 14 for a transmitting device.

The method according to the third aspect can be extended into implementation forms corresponding to the implementation forms of the transmitting device according to the first aspect. Hence, an implementation form of the method comprises the feature(s) of the corresponding implementation form of the transmitting device.

The advantages of the methods according to the third aspect are the same as those for the corresponding implementation forms of the transmitting device according to the first aspect. According to a fourth aspect of the invention, the above mentioned and other objectives are achieved with a method according to claim 15 for a receiving device.

The method according to the fourth aspect can be extended into implementation forms corresponding to the implementation forms of the receiving device according to the second aspect. Hence, an implementation form of the method comprises the feature(s) of the corresponding implementation form of the receiving device.

The advantages of the methods according to the fourth aspect are the same as those for the corresponding implementation forms of the receiving device according to the second aspect. The invention also relates to a computer program, characterized in code means, which when run by processing means causes said processing means to execute any method according to the present invention. Further, the invention also relates to a computer program product comprising a computer readable medium and said mentioned computer program, wherein said computer program is included in the computer readable medium, and comprises of one or more from the group: ROM (Read-Only Memory), PROM (Programmable ROM), EPROM (Erasable PROM), Flash memory, EEPROM (Electrically EPROM) and hard disk drive. Further applications and advantages of the present invention will be apparent from the following detailed description.

## Brief Description of the Drawings

The appended drawings are intended to clarify and explain different embodiments of the present invention, in which:

- Fig. 1 shows a transmitting device according to an embodiment of the invention;
- Fig. 2 shows a receiving device according to an embodiment of the invention;
- Fig. 3 shows an interleaver structure according to an embodiment of the present invention;
- Fig. 4 shows different structures of LDPC codewords according to an embodiment of the invention;
- Fig. 5 shows an interleaver structure according to an embodiment of the invention;
- Fig. 6 shows a method for a transmitting device according to an embodiment of the invention;
- Fig. 7 shows a method for a receiving device according to an embodiment of the invention; and
- Fig. 8 shows performance of bit-interleaved LDPC according to embodiments of the invention compared with non bit-interleaved LDPC.

## Detailed Description

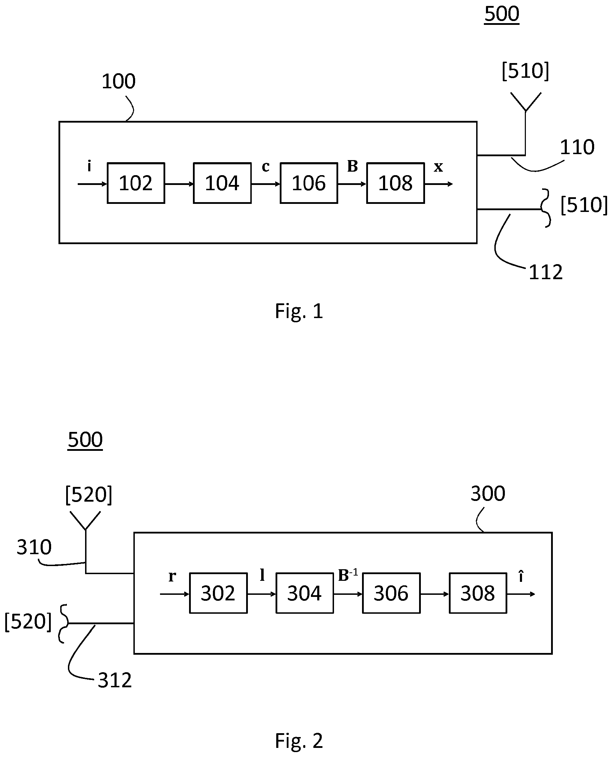

Fig. 1 shows a block scheme of a transmitting device 100 according to an embodiment of the invention. A block scheme of a corresponding receiving device 300 according to an embodiment of the invention is shown in Fig. 2. For providing an understanding of the invention mentioned embodiments are described in a LDPC-coded transmission scheme using QAM modulation without being limited thereto. Other codes and modulation techniques can be used in conjunction with the invention. For example, any linear block codes, such as turbo codes, serially-concatenated convolutional codes, Reed-Solomon (R-S) codes, Bose-Chaudhuri-Hocquenghem (BCH) codes, and polar codes can be used in conjunction with the invention. As for modulation techniques, any modulation techniques, such as M-QAM, M-PSK, M-PPM, can be used in conjunction with the invention.

The transmitting device 100 according to the embodiment in Fig. 1 comprises an encoder 102 (in this example a LDPC encoder), a rate matcher 104, an interleaver 106, and a mapper 108 (in this example a QAM mapper) coupled to each other as illustrated in Fig. 1. The transmitting device 100 further comprises wireless 110 and/or wired 112 communication means since the present transmitting device 100 can operate in a wireless communication system, a wired communication system or in a combination thereof.

The encoder 102 is configured to obtain an information message comprising information bits addressed for a receiving device 300 (see Fig. 2). The encoder 102 is further configured to encode the information message so as to obtain a codeword and forward the codeword to the rate matcher 104. The LDPC encoder 102 receives an information message I comprising information bits and encodes the information message I so as to generate a codeword c. At the output of the LDPC encoder 102, the generated codeword vector c has length $n$ bits. The first $k - 2Z$ components of the codeword vector c are systematic bits and the remaining components of the codeword vector c are parity-check bits in the non rate-matched case.

Upon reception of the codeword c the rate matcher 104 is configured to rate-match the codeword c so as to produce a rate-matched codeword comprising systematic bits and parity-check bits, the latter also known as redundancy bits. In an initial transmission, denoted by redundancy version $rv = 0$, the rate matcher 104 punctures the last parity-check bits of the codeword c and none of the initial systematic bits in the codeword are punctured. In subsequent transmissions, the rate matcher 104 punctures the systematic bits and the parity-check bits, where the redundancy version $rv$ indicates a combination of systematic and parity-check bits that are punctured.

The interleaver 106 receiving the rate-matched codeword is configured to jointly interleave the systematic bits and parity-check bits of the rate-matched codeword so as to obtain an interleaved codeword. The interleaved codeword is generally a matrix having m columns and s rows, wherein m is the number of bits in the labels of the modulation constellation, and wherein s times m is at least equal to the length of the codeword. It should however be noted that in the case no rate-matching is performed, the input to the interleaver 106 will be a non rate-matched codeword c. In this operation of the interleaver 106 the systematic bits of the interleaved codeword c are mapped to modulation label positions of a modulation constellation with first reliabilities and the parity-check bits of the interleaved codeword are mapped to modulation label positions of the modulation constellation with second reliabilities, such that each first reliability is higher than any second reliability in an initial transmission, and each first reliability is lower than any second reliability in a re-transmission. The codeword c = $(c_1, c_2, \cdots c_n)$ is then mapped to $s = \lceil n/m \rceil$ modulation symbols, where M = $2^m$ is the size of the modulator constellation. Mapping to modulation symbols is performed in the following way: the codeword c is first interleaved by writing it column-wise to a matrix B of size s × m (s rows, m columns), starting from the upper left corner and proceeding top-to-bottom first and then left-to-right. In this way, the (k - 2Z) systematic bits in the codeword c will be written in the leftmost $\lceil (k - 2Z)/s \rceil$ columns. If the codeword size $n$ is not an integer multiple of m, then $N_z = (sm - n)$ zero-padding bits are inserted at the end of the last column of matrix B. In this way, the interleaver can handle codewords c of any integer size.

The content of matrix B is then read out row-wise, starting from the first row. The $r$th row $b_r = (b_{r,0}, ..., b_{r,m-1})$ is read as a m-tuple $b(i), ..., b(i + m - 1)$ and mapped to a complex-valued QAM symbol $x = I + jQ$ in the mapper 108. According to the modulation mapping therein specified, in the m-tuple $b(i), ..., b(i + m - 1)$ bits are arranged in non-increasing order of bit-level capacity, i.e., $b(i), b(i + 1)$ have the highest bit-level capacity, $b(i + 2), b(i + 3)$ have the second highest bit-level capacity, ..., $b(i + m - 2), b(i + m - 1)$ have the lowest bit-level capacity. After QAM mapping, the complex modulation symbols x are collected into a signal vector x and transmitted to the receiving device 300 in a communication system 500.

The proposed interleaver operations permute the bit positions in a codeword so that the resulting permuted codeword contains a sequence of segments of coded bits, with each segment intended to be mapped to a separate modulation symbol. Each segment contains parity check bits and systematic bits arranged in a desired order. The interleaver herein therefore jointly interleaves/permutes the systematic bits and the parity-check bits. Each first reliability is higher than any second reliability in an initial transmission, and the initial transmission is performed when a new information message is transmitted to the receiving device. Each first reliability is lower than any second reliability in a re-transmission, and the re-transmission occurs when the initial transmission was unsuccessful and/or the receiving device indicates to the transmitting device that it did not successfully decode the information message. This may e.g. relate to re-transmission schemes, such as HARQ, etc. The re-transmission is performed after the initial transmission.

Furthermore, as previously described there are cases with $rv = 0$ (i.e. the initial transmission) in which none of the initial systematic bits in the codeword c are punctured and cases with $rv > 0$ in which systematic bits are punctured.

Arranging systematic bits in the most reliable modulation bit label positions provides a higher robustness against transmission errors in the initial transmission, as the systematic bits are delivered to the receiver with higher reliability, thereby obtaining a better error protection for the transmitted information message.

For re-transmission, arranging parity-check bits in the most reliable modulation bit label positions helps the decoder to increase the coding gain, thereby resulting in a better error protection for the transmitted information message when decoding is performed after a re-transmission.

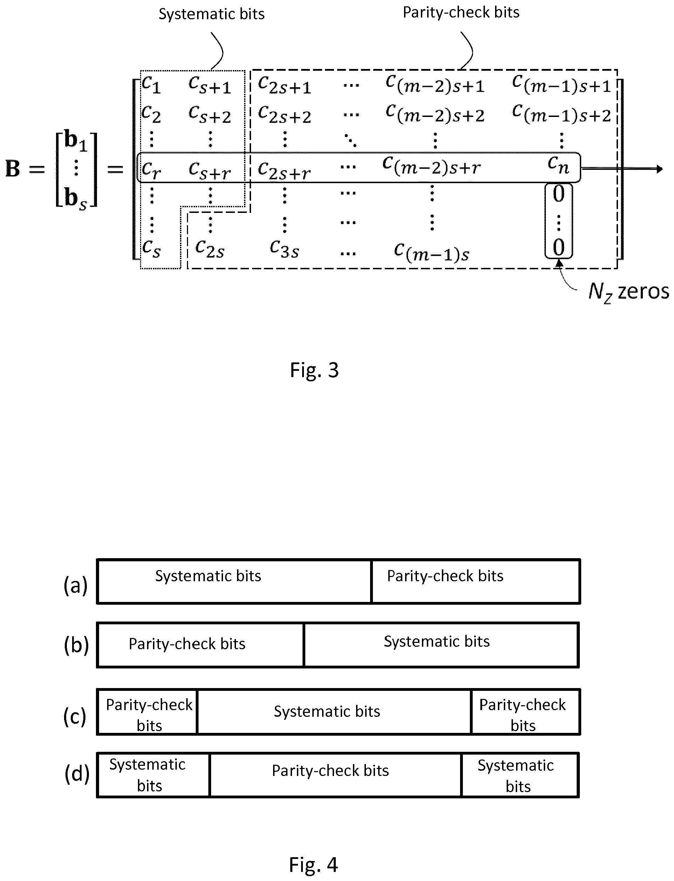

In the initial transmission case, i.e., $rv = 0$, the content of matrix B can be written as in Fig. 3, where the information bits are in the left-most positions and the parity-check bits are in the right-most positions. This structure can be interpreted as a maximum-distance interleaver 106 with a particular ordering of the systematic bits and the parity-check bits of the codeword c. The interleaver 106 jointly permutes the systematic bits and the parity-check bits and, at the same time, produces an ordering in which the systematic bits of the interleaved codeword c are mapped to modulation label positions of a modulation constellation with first reliabilities and the parity-check bits of the interleaved codeword c are mapped to modulation label positions of the modulation constellation with second reliabilities, wherein each first reliability is higher than any second reliability.

The cases of re-transmissions are now considered, i.e., when the redundancy version is $rv \geq 1$. In this case, the codeword c is provided by the encoder 102 and the rate-matcher 104 to the interleaver 106. The rate-matcher 104 writes the LDPC encoder output into a circular buffer and then starts reading the bits in the circular buffer from a certain position. The initial position reading position in the circular buffer may correspond to systematic bit or a parity-check bit. Thus, the codeword c entering the interleaver 106 may have one of the structures shown in Fig. 4. For all cases except case (a) in Fig. 4, which corresponds to the non rate-matched case, the systematic bits would not be placed in the leftmost columns of matrix **B**. Therefore, those systematic bits would not be mapped to most reliable modulation bits by the interleaver 106. However, having parity-check bits mapped to most reliable positions may be beneficial in a re-transmission following an initial transmission where systematic bits are mapped to most reliable modulation bits. This behaviour has been observed in simulations and can be explained by the higher coding gain brought by highly reliable parity-check bits.

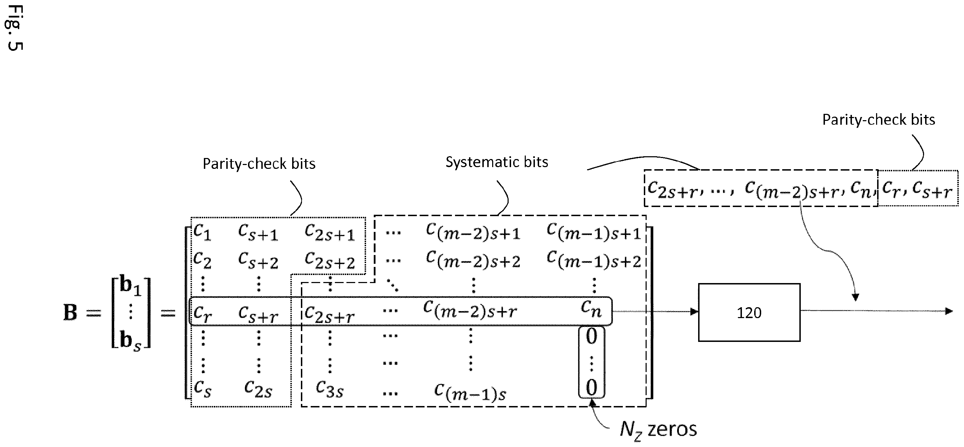

In order to obtain the desired mapping of the systematic bits and the parity-check bits, it is disclosed an interleaver structure and mapping to modulation symbols as shown Fig. 5. In order to obtain the desired mapping, the bits in each row of the matrix **B** are permuted using a row interleaver 120 prior to modulation mapping. The row interleaver 120 permutes the m bits in each row of matrix **B** in a way that, after interleaving, the systematic bits are mapped to the most reliable or least reliable bits in the modulation label depending on if the transmission is an initial transmission or a re-transmission. In the following disclosure two main solutions for structuring the rows of the matrix using the row interleaver 120 are described. In one solution circular shift is applied on each row of the matrix **B,** and in another solution two sub-rows are formed for each row the matrix **B,** wherein one sub-row comprises all systematic bits of a row and another one sub-row comprises all parity-check bits of the row.

According to an embodiment, the row interleaver 120 performs a left circular shift of each row of the matrix in the initial transmission. In the example shown in Fig. 5, each row is left-circularly shifted until all systematic bits in that row occupy the first (left-most) positions and all parity-check bits occupy the last (right-most) positions. After row interleaving, each row is mapped to a modulation symbol. Hence, the row interleaver 120 herein is configured to circularly shift each row of the matrix so as to obtain a re-arranged row for each row of the matrix in which all systematic bits of a row of the matrix are arranged in the left-most positions of a re-arranged row and all parity-check bits of the row of the matrix are arranged in the right-most positions of the re-arranged row. The bits in the left-most positions of the re-arranged row are mapped to modulation label positions of the modulation constellation with the first reliability and bits in the right-most positions of the re-arranged row are mapped to modulation label positions of the modulation constellation with the second reliability.

According to another embodiment, the row interleaver 120 performs a left circular shift of each row of the matrix in the re-transmission. In an example, each row is left-circularly shifted until all parity-check bits in that row occupy the first (left-most) positions and all systematic bits occupy the last (right-most) positions. After row interleaving, each row is mapped to a modulation symbol. Hence, the row interleaver 120 herein is configured to circularly shift each row of the matrix so as to obtain a re-arranged row for each row of the matrix in which all parity-check bits of a row of the matrix are arranged in the left-most positions of a re-arranged row and all systematic bits of the row of the matrix are arranged in the right-most positions of the re-arranged row. The bits in the left-most positions of the re-arranged row are mapped to modulation label positions of the modulation constellation with the second reliability and bits in the right-most positions of the re-arranged row are mapped to modulation label positions of the modulation constellation with the first reliability.

At transmission each re-arranged row is mapped onto a modulation symbol of the modulation constellation so as to obtain a plurality of modulation symbols. The plurality of modulation symbols are transmitted in a communication signal 510, in vector form denoted x, to the receiving device 300.

According to another embodiment, the row interleaver 120 herein is configured to select all systematic bits of each row of the matrix B so as obtain a first sub-row for each row of the matrix B in the initial transmission. The first sub-row comprises all systematic bits of a row of the matrix **B,** and the bits in the first sub-row are mapped to modulation label positions of the modulation constellation with the first reliability. Hence, in this first step the row interleaver 120 reads all the systematic bits in its input vector sequentially from left to right, skipping the parity-check bits, and sends those bits to its output. The row interleaver 120 is further configured to select all parity-check bits of each row of the matrix **B** so as obtain a second sub-row for each row of the matrix **B**. The second sub-row comprises all parity-check bits of a row of the matrix **B,** and the bits in the second sub-row are mapped to modulation label positions of the modulation constellation with the second reliability. Hence, in this second step, the row interleaver 120 sequentially reads all the parity-check bits in its input vector from left to right, skipping the systematic bits, and sends the read bits to its output.

According to another embodiment, the row interleaver 120 herein is configured to select all parity-check bits of each row of the matrix **B** so as obtain a first sub-row for each row of the matrix **B** in the re-transmission. The first sub-row comprises all parity-check bits of a row of the matrix **B,** and the bits in the first sub-row are mapped to modulation label positions of the modulation constellation with the second reliability. Hence, in this first step the row interleaver 120 reads all the parity-check bits in its input vector sequentially from left to right, skipping the systematic bits, and sends those bits to its output. The row interleaver 120 is further configured to select all systematic bits of each row of the matrix **B** so as obtain a second sub-row for each row of the matrix **B**. The second sub-row comprises all systematic bits of a row of the matrix **B,** and the bits in the second sub-row are mapped to modulation label positions of the modulation constellation with the first reliability. Hence, in this second step, the row interleaver 120 sequentially reads all the systematic bits in its input vector from left to right, skipping the parity-check bits, and sends the read bits to its output.

At transmission, the first sub-row and the second sub-row of each row in the matrix **B** are combined so as to obtain a combined row for each row of the matrix **B**. Each combined row is mapped to a modulation symbol of the modulation constellation so as to obtain a plurality of modulation symbols. The plurality of modulation symbols are transmitted in a communication signal **x** to the receiving device 300.

By using the row interleaver 120 described in above embodiments, cases (c) and (d) in Fig. 4 are handled in the same way as case (b). It is further beneficial to consider that any row interleaver 120 does not change positions of the $N_z$ zeros in the lower-right part of the matrix **B,** as those zeros are already occupying low-reliability positions and therefore moving them to other higher-reliability positions would result in a waste of communication resources.

Fig. 2 shows a receiving device 300 according to an embodiment of the invention. The receiving device 300 in Fig. 2 comprises a de-mapper 302 (in this example a soft de-mapper), a de-interleaver 304, a de-rate-matcher 306, and a decoder 308 (in this example a LDCP decoder) coupled to each other as illustrated in Fig. 2. The receiving device 300 further comprises wireless 310 and/or wired 312 communication means since the present receiving device 300 can operate in wireless communication systems, wired communication systems or in a combination thereof. Generally, the receiving device 300 is configured to perform the invers operations as the ones performed by the transmitting device 100 according to the invention.

A communication signal 520, in vector form denoted r, comprising a plurality of modulation symbols is received by the receiving device 300 and forwarded to the de-mapper 302. The received communication signal 520 is the transmitted communication signal 510 after having propagated through one or more channels, such as a radio channel or a wired communication channel.

The de-mapper 302 is configured to de-map the plurality of modulation symbols so as to obtain a plurality of soft bit labels. Each soft bit label of the plurality of soft bit labels comprises systematic soft bits and parity-check soft bits.

The deinterleaver 304 is configured to deinterleave the plurality of soft bit labels so as to obtain a deinterleaved soft codeword which spans the plurality of modulation symbols. The systematic soft bits of the plurality of soft bit labels are de-mapped from modulation label positions of a modulation constellation with first reliabilities and the parity-check soft bits of the plurality of soft bit labels are de-mapped from modulation label positions of the modulation constellation with second reliabilities, and each first reliability is higher than any second reliability in the initial reception, i.e. reception corresponding to an initial transmission, and each first reliability is lower than any second reliability in the subsequent reception, i.e. subsequent reception corresponding to a re-transmission. De-interleaving consists in performing the inverse operation as the one performed by the interleaver 106 in the transmitting device 100 so the deinterleaver 304 obtains as its input the vector 1 = $(I_1, ..., I_n)$ of soft demodulated symbols and writes the vector 1 row-wise into a matrix **B$^{-1}$** of the same size as **B**, i.e., s × m (s rows, m columns) starting from the upper left corner and proceeding left to right first and then top to bottom. The content of **B$^{-1}$** is read out column-wise from top to bottom first and then left to right to the de-rate-matcher 306.

The de-rate-matcher 306 is configured to de-rate-match the deinterleaved soft codeword received from the deinterleaver 304 so as to obtain a de-rate-matched soft codeword.

Finally, the de-rate-matched soft codeword is sent to the LDPC decoder 308 for decoding so as to output an information message.

In further embodiments of the invention a control signalling mechanism from the transmitting device 100 to the receiving device 300 is provided. Therefore, the transmitting device 100 is configured to determine a control message. The control message comprises an indication of a number of information bits of the information message, a number of encoded bits of the codeword, and a modulation order of the modulation symbol. The transmitting device 100 transmits the control message to the receiving device 300 (not shown in the Figs.).

Correspondingly, the receiving device 300 is configured to obtain a control message. The control message comprises an indication of a number of information bits of the information message, a number of encoded bits of the codeword, and a modulation order of the modulation symbol. The receiving device 300 uses the information in the control message for deinterleaving the plurality of soft labels. Therefore, the receiving device 300 will be informed about the number of information bits, number of coded bits in the transmitted codeword and modulation order. The only additional information that the receiving device 300 further needs in order to determine the interleaver structure is knowledge of the redundancy version *rv.* This information about the redundancy version *rv* can be obtained, for example, from a local scheduler that computes transmission parameters for each transmission based on channel quality information, or from a remote device through a control channel, etc.

The receiving device 300 can receive the control message from a scheduler, a control node of the communication system, or directly from the transmitting device 100.

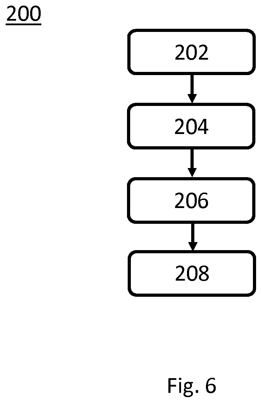

Fig. 6 shows a flow chart of a method according to an embodiment of the invention. The method can be implemented in a transmitting device 100, such as the one in Fig. 1. The method 200 comprises obtaining 202 an information message comprising information bits addressed for a receiving device 300. The method 200 further comprises encoding 204 the information message so as to obtain a codeword. The method 200 further comprises rate-matching 206 the codeword so as to produce a rate-matched codeword comprising systematic bits and parity-check bits. The method 200 further comprises jointly interleaving 208 the systematic bits and parity-check bits of the rate-matched codeword so as to obtain an interleaved codeword, wherein the systematic bits of the interleaved codeword are mapped to modulation label positions of a modulation constellation with first reliabilities and the parity-check bits of the interleaved codeword are mapped to modulation label positions of the modulation constellation with second reliabilities.

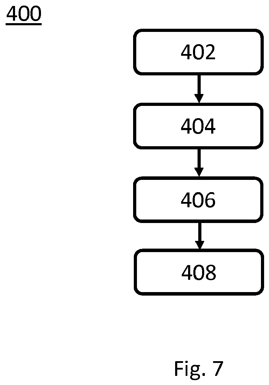

Fig. 7 shows a flow chart of a corresponding method according to an embodiment of the invention. The method can be implemented in a receiving device 100, such as the one in Fig. 2. The method 400 comprises receiving 402 a communication signal 520 from a transmitting device 100, wherein the communication signal 520 comprises a plurality of modulation symbols. The method 400 further comprises de-mapping 404 the plurality of modulation symbols so as to obtain a plurality of soft bit labels, wherein each soft bit label of the plurality of soft bit labels comprises systematic soft bits and parity-check soft bits. The method 400 further comprises deinterleaving 406 the plurality of soft bit labels so as to obtain a deinterleaved soft codeword, wherein the systematic soft bits of the plurality of soft bit labels are de-mapped from modulation label positions of a modulation constellation with first reliabilities and the parity-check soft bits of the plurality of soft bit labels are de-mapped from modulation label positions of the modulation constellation with second reliabilities. The method 400 further comprises de-rate-matching 408 the deinterleaved soft codeword so as to obtain a de-rate-matched soft codeword.

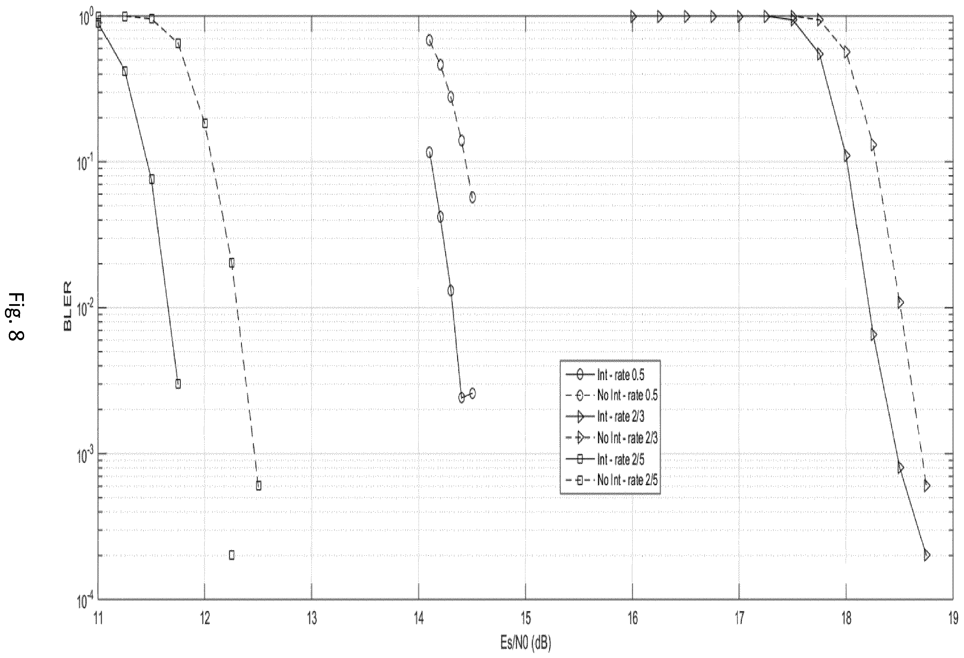

In this section some performance results for embodiments of the invention are presented with reference to Fig. 8. In this respect simulations have been performed and the simulation parameters are summarized in Table 1. The parity-check matrices were constructed using base matrix 1 as agreed in RAN1.

Table 1: Simulation parameters.

| Channel model | AWGN |
|---|---|
| Modulation | 256QAM |
| Codeword length | 12320, 9856, 7392 |
| Information word length | 4928 |
| Code rate | 0.4, 0.5, 0.667 |
| Decoding iterations | 50, flooding BP |

The x-axis shows signal-to-noise ratio (SNR) and the y-axis shows the block error rate (BLER). Fig. 8 shows the BLER performance of an LDPC-coded system using embodiments of the invention (solid lines) compared with a LDPC-coded system without interleaving (dashed lines). In these evaluations, it is assumed the initial transmission case, i.e. *rv* = 0. We observe that significant gains can be obtained using the present interleaver. It can be derived from Fig. 8 that a gain of 0.25, 0.3, 0.625 dB corresponding to code rates 0.667, 0.5 and 0.4 is seen for BLER = 0.1.

Table 2: SNR gain for block length *K*=4928 bits and 256QAM modulation.

| Code rate | SNR gain @ BLER=$10^{-1}$ |
|---|---|
| 2/5 | 0.625 |

(continued)

| Code rate | SNR gain @ BLER=$10^{-1}$ |
|---|---|
| 1/2 | 0.3 |
| 2/3 | 0.25 |

The transmitting device 100 and the receiving device 300 may be any type of communication device with the capabilities to transmit, respectively, receive communication signals in a communication system 500. Mentioned communication system 500 may be a wireless communication system, a wired communication system or in a combination thereof. Examples of such communication systems are LTE, LTE Advanced, NR, WiFi, HSPA, HSDPA and Wideband CDMA.

In embodiments the transmitting device 100 and the receiving device 300 are a client device or a network access node.

The client device herein, may be denoted as a user device, a User Equipment (UE), a mobile station, an internet of things (IoT) device, a sensor device, a wireless terminal and/or a mobile terminal, is enabled to communicate wirelessly in a wireless communication system, sometimes also referred to as a cellular radio system. The UEs may further be referred to as mobile telephones, cellular telephones, computer tablets or laptops with wireless capability. The UEs in the present context may be, for example, portable, pocket-storable, hand-held, computer-comprised, or vehicle-mounted mobile devices, enabled to communicate voice and/or data, via the radio access network, with another entity, such as another receiver or a server. The UE can be a Station (STA), which is any device that contains an IEEE 802.11-conformant Media Access Control (MAC) and Physical Layer (PHY) interface to the Wireless Medium (WM). The UE may also be configured for communication in 3GPP related LTE and LTE-Advanced, in WiMAX and its evolution, and in fifth generation wireless technologies, such as New Radio.

The network access node herein may also be denoted as a radio network access node, an access network access node, an access point, or a base station, e.g. a Radio Base Station (RBS), which in some networks may be referred to as transmitter, "eNB", "eNodeB", "NodeB" or "B node", depending on the technology and terminology used. The radio network access nodes may be of different classes such as e.g. macro eNodeB, home eNodeB or pico base station, based on transmission power and thereby also cell size. The radio network access node can be a Station (STA), which is any device that contains an IEEE 802.11-conformant Media Access Control (MAC) and Physical Layer (PHY) interface to the Wireless Medium (WM). The radio network access node may also be a base station corresponding to the fifth generation (5G) wireless systems.

Furthermore, any method according to embodiments of the invention may be implemented in a computer program, having code means, which when run by processing means causes the processing means to execute the steps of the method. The computer program is included in a computer readable medium of a computer program product. The computer readable medium may comprise essentially any memory, such as a ROM (Read-Only Memory), a PROM (Programmable Read-Only Memory), an EPROM (Erasable PROM), a Flash memory, an EEPROM (Electrically Erasable PROM), or a hard disk drive.

Moreover, it is realized by the skilled person that embodiments of the transmitting device 100 and the receiving device 300 comprises the necessary communication capabilities in the form of e.g., functions, means, units, elements, etc., for performing the present solution. Examples of other such means, units, elements and functions are: processors, memory, buffers, control logic, encoders, decoders, rate matchers, de-rate matchers, mapping units, multipliers, decision units, selecting units, switches, interleavers, de-interleavers, modulators, demodulators, inputs, outputs, antennas, amplifiers, receiver units, transmitter units, DSPs, MSDs, TCM encoder, TCM decoder, power supply units, power feeders, communication interfaces, communication protocols, etc. which are suitably arranged together for performing the present solution.

Especially, the processor(s) of the transmitting device 100 and the receiving device 300 may comprise, e.g., one or more instances of a Central Processing Unit (CPU), a processing unit, a processing circuit, a processor, an Application Specific Integrated Circuit (ASIC), a microprocessor, or other processing logic that may interpret and execute instructions. The expression "processor" may thus represent a processing circuitry comprising a plurality of processing circuits, such as, e.g., any, some or all of the ones mentioned above. The processing circuitry may further perform data processing functions for inputting, outputting, and processing of data comprising data buffering and device control functions, such as call processing control, user interface control, or the like.

Finally, it should be understood that the invention is not limited to the embodiments described above, but also relates to and incorporates all implementations within the scope of the appended independent claims.

**Claims**

1. A transmitting device (100) for a communication system (500), the transmitting device (100) being configured to

   obtain an information message comprising information bits addressed for a receiving device (300);
   encode the information message so as to obtain a codeword;
   rate-match the codeword so as to produce a rate-matched codeword comprising systematic bits and parity-check bits;
   jointly interleave the systematic bits and parity-check bits of the rate-matched codeword so as to obtain an interleaved codeword, wherein the rate-matched codeword is interleaved by writing it column-wise to a matrix, starting from the upper left corner and proceeding top-to-bottom first and then left-to-right, wherein the interleaved codeword is a matrix having m columns and s rows, wherein m is the number of bits in labels of the modulation constellation, and wherein s times m is at least equal to the length of the codeword; and
   map the systematic bits of the interleaved codeword to modulation label positions of a modulation constellation with first reliabilities, and map the parity-check bits of the interleaved codeword to modulation label positions of the modulation constellation with second reliabilities, wherein the content of the matrix is read out row-wise, starting from the first row, wherein each first reliability is higher than any second reliability in an initial transmission, and each first reliability is lower than any second reliability in a re-transmission.

2. The transmitting device (100) according to claim 1, configured to, in the initial transmission,
   circularly shift each row of the matrix so as to obtain a re-arranged row for each row of the matrix, wherein systematic bits of a row of the matrix are arranged in the left-most positions of a re-arranged row and parity-check bits of the row of the matrix are arranged in the right-most positions of the re-arranged row, wherein bits in the left-most positions of the re-arranged row are mapped to modulation label positions of the modulation constellation with a first reliability and bits in the right-most positions of the re-arranged row are mapped to modulation label positions of the modulation constellation with a second reliability.

3. The transmitting device (100) according to claim 1, configured to, in the re-transmission,
   circularly shift each row of the matrix so as to obtain a re-arranged row for each row of the matrix, wherein systematic bits of a row of the matrix are arranged in the right-most positions of a re-arranged row and parity-check bits of the row of the matrix are arranged in the left-most positions of the re-arranged row, wherein bits in the left-most positions of the re-arranged row are mapped to modulation label positions of the modulation constellation with a second reliability and bits in the right-most positions of the re-arranged row are mapped to modulation label positions of the modulation constellation with a first reliability.

4. The transmitting device (100) according to claim 2 or 3, configured to

   map each re-arranged row onto a modulation symbol of the modulation constellation so as to obtain a plurality of modulation symbols;
   transmit the plurality of modulation symbols in a communication signal (510) to the receiving device (300).

5. The transmitting device (100) according to claim 1, configured to, in the initial transmission,

   select systematic bits of each row of the matrix so as obtain a first sub-row for each row of the matrix, wherein a first sub-row comprises the systematic bits of a row of the matrix, wherein bits in the first sub-row are mapped to modulation label positions of the modulation constellation with a first reliability;
   select parity-check bits of each row of the matrix so as obtain a second sub-row for each row of the matrix, wherein a second sub-row comprises the parity-check bits of a row of the matrix, wherein bits in the second sub-row are mapped to modulation label positions of the modulation constellation with a second reliability.

6. The transmitting device (100) according to claim 1, configured to, in the re-transmission,

   select parity-check bits of each row of the matrix so as obtain a first sub-row for each row of the matrix, wherein a first sub-row comprises the parity-check bits of a row of the matrix, wherein bits in the first sub-row are mapped to modulation label positions of the modulation constellation with a second reliability;
   select systematic bits of each row of the matrix so as obtain a second sub-row for each row of the matrix, wherein a second sub-row comprises the systematic bits of a row of the matrix, wherein bits in the second sub-row are mapped to modulation label positions of the modulation constellation with a first reliability.

**7.** The transmitting device (100) according to claim 5 or 6, configured to

combine the first sub-row and the second sub-row of each row in the matrix so as to obtain a combined row for each row of the matrix;
map each combined row to a modulation symbol of the modulation constellation so as to obtain a plurality of modulation symbols;
transmit the plurality of modulation symbols in a communication signal (510) to the receiving device (300).

**8.** The transmitting device (100) according to claim 4 or 7, configured to

determine a control message, wherein the control message comprises an indication of a number of information bits of the information message, a number of encoded bits of the codeword, and a modulation order of the modulation symbol;
transmit the control message to the receiving device (300).

**9.** The transmitting device (100) according to any of the preceding claims, wherein the modulation constellation is a quadrature amplitude modulation constellation.

**10.** The transmitting device (100) according to any of the preceding claims, wherein the codeword belongs to a low-density parity-check code book.

**11.** A receiving device (300) for a communication system (500), the receiving device (300) being configured to

receive a communication signal (520) from a transmitting device (100), wherein the communication signal (520) comprises a plurality of modulation symbols;
de-map the plurality of modulation symbols so as to obtain a plurality of soft bit labels, wherein each soft bit label of the plurality of soft bit labels comprises systematic soft bits and parity-check soft bits, wherein the plurality of soft bit labels are written row-wise into a matrix, starting from the upper left corner and proceeding left to right first and then top to bottom, wherein the matrix has m columns and s rows, wherein m is the number of bits in labels of the modulation constellation, wherein the systematic soft bits of the plurality of soft bit labels are de-mapped from modulation label positions of a modulation constellation with first reliabilities and the parity-check soft bits of the plurality of soft bit labels are de-mapped from modulation label positions of the modulation constellation with second reliabilities, wherein each first reliability is higher than any second reliability in an initial reception, and each first reliability is lower than any second reliability in a subsequent reception;
deinterleave the plurality of soft bit labels so as to obtain a deinterleaved soft codeword, wherein the content of the matrix is read out column-wise from top to bottom first and then left to right; and
de-rate-match the deinterleaved soft codeword so as to obtain a de-rate-matched soft codeword.

**12.** The receiving device (300) according to claim 11, configured to
decode the de-rate matched soft codeword so as to obtain an information message.

**13.** The receiving device (300) according to any of claims 11 or 12, configured to

obtain a control message, wherein the control message comprises an indication of a number of information bits of the information message, a number of encoded bits of the codeword, and a modulation order of the modulation symbol;
deinterleave the plurality of soft labels based on the control message.

**14.** A method for a transmitting device (100), the method (200) comprising

obtaining (202) an information message comprising information bits addressed for a receiving device (300);
encoding (204) the information message so as to obtain a codeword;
rate-matching (206) the codeword so as to produce a rate-matched codeword comprising systematic bits and parity-check bits;
jointly interleaving (208) the systematic bits and parity-check bits of the rate-matched codeword so as to obtain an interleaved codeword, wherein the rate-matched codeword is interleaved by writing it column-wise to a matrix, starting from the upper left corner and proceeding top-to-bottom first and then left-to-right, wherein the interleaved codeword is a matrix having m columns and s rows, wherein m is the number of bits in labels of the modulation constellation, and wherein s times m is at least equal to the length of the codeword; and mapping the systematic bits of the interleaved codeword to modulation label positions of a modulation constellation with first reliabilities, and mapping the parity-check bits of the interleaved codeword to modulation label positions of the modulation constellation with second reliabilities, wherein the content of the matrix is read out row-wise, starting from the first row, wherein each first reliability is higher than any second reliability in an initial transmission, and each first reliability is lower than any second reliability in a re-transmission.

15. A method for a receiving device (300), the method (400) comprising

receiving (402) a communication signal (520) from a transmitting device (100), wherein the communication signal (520) comprises a plurality of modulation symbols;
de-mapping (404) the plurality of modulation symbols so as to obtain a plurality of soft bit labels, wherein each soft bit label of the plurality of soft bit labels comprises systematic soft bits and parity-check soft bits, wherein the plurality of soft bit labels are written row-wise into a matrix, starting from the upper left corner and proceeding left to right first and then top to bottom, wherein the matrix has m columns and s rows, wherein m is the number of bits in labels of the modulation constellation, wherein the systematic soft bits of the plurality of soft bit labels are de-mapped from modulation label positions of a modulation constellation with first reliabilities and the parity-check soft bits of the plurality of soft bit labels are de-mapped from modulation label positions of the modulation constellation with second reliabilities, wherein each first reliability is higher than any second reliability in an initial reception, and each first reliability is lower than any second reliability in a subsequent reception;
deinterleaving (406) the plurality of soft bit labels so as to obtain a deinterleaved soft codeword, wherein the content of the matrix is read out column-wise from top to bottom first and then left to right; and
de-rate-matching (408) the deinterleaved soft codeword so as to obtain a de-rate-matched soft codeword.

16. A computer program with a program code for performing a method according to claim 14 or 15 when the computer program runs on a computer.


**Patentansprüche**

1. Übertragungsvorrichtung (100) für ein drahtloses Kommunikationssystem (500), wobei die Übertragungsvorrichtung (100) zu Folgendem konfiguriert ist:

Erlangen einer Informationsnachricht, die Informationsbits umfasst, die an eine Empfangsvorrichtung (300) adressiert sind; Kodieren der Informationsnachricht, um ein Codewort zu erlangen; Ratenabgleichen des Codeworts, um ein ratenabgeglichenes Codewort zu generieren, das systematische Bits und Paritätsprüfbits umfasst;
gemeinsames Verschachteln der systematischen Bits und Paritätsprüfbits des ratenabgeglichenen Codeworts, um ein verschachteltes Codewort zu erlangen, wobei das ratenabgeglichene Codewort durch spaltenweises Schreiben in eine Matrix verschachtelt wird, beginnend in der oberen linken Ecke und fortfahrend zuerst von oben nach unten und dann von links nach rechts, wobei das verschachtelte Codewort eine Matrix mit m Spalten und s Zeilen ist, wobei $m$ die Anzahl der Bits in Labels der Modulationskonstellation ist und wobei s mal m mindestens gleich der Länge des Codeworts ist; und
Abbilden der systematischen Bits des verschachtelten Codeworts auf Modulations-Label-Positionen einer Modulationskonstellation mit ersten Zuverlässigkeiten und Abbilden der Paritätsprüfbits des verschachtelten Codeworts auf Modulations-Label-Positionen der Modulationskonstellation mit zweiten Zuverlässigkeiten, wobei der Inhalt der Matrix zeilenweise gelesen wird, beginnend mit der ersten Zeile, wobei bei einer Erstübertragung jede erste Zuverlässigkeit höher ist als jede zweite Zuverlässigkeit und bei einer erneuten Übertragung jede erste Zuverlässigkeit niedriger ist als jede zweite Zuverlässigkeit.

2. Übertragungsvorrichtung (100) nach Anspruch 1, die bei der anfänglichen Übertragung zu Folgendem konfiguriert ist:
kreisförmiges Verschieben jeder Zeile der Matrix, um für jede Zeile der Matrix eine neu angeordnete Zeile zu erlangen, wobei systematische Bits einer Zeile der Matrix an den äußersten linken Positionen einer neu angeordneten Zeile angeordnet werden und Paritätsprüfbits der Zeile der Matrix an den äußerst rechten Positionen der neu angeordneten Zeile angeordnet werden, wobei Bits an den äußersten linken Positionen der neu angeordneten Zeile mit einer ersten Zuverlässigkeit auf Modulations-Label-Positionen der Modulationskonstellation abgebildet werden und Bits an den äußersten rechten Positionen der neu angeordneten Zeile mit einer zweiten Zuverlässigkeit auf Modulations-Label-Positionen der Modulationskonstellation abgebildet werden.

**3.** Übertragungsvorrichtung (100) nach Anspruch 1, die bei der erneuten Übertragung zu Folgendem konfiguriert ist: kreisförmiges Verschieben jeder Zeile der Matrix, um für jede Zeile der Matrix eine neu angeordnete Zeile zu erlangen, wobei systematische Bits einer Zeile der Matrix an den äußersten rechten Positionen einer neu angeordneten Zeile angeordnet werden und Paritätsprüfbits der Zeile der Matrix an den äußerst linken Positionen der neu angeordneten Zeile angeordnet werden, wobei Bits an den äußersten linken Positionen der neu angeordneten Zeile mit einer zweiten Zuverlässigkeit auf Modulations-Label-Positionen der Modulationskonstellation abgebildet werden und Bits an den äußersten rechten Positionen der neu angeordneten Zeile mit einer ersten Zuverlässigkeit auf Modulations-Label-Positionen der Modulationskonstellation abgebildet werden.

**4.** Übertragungsvorrichtung (100) nach Anspruch 2 oder 3, die zu Folgendem konfiguriert ist:

Abbilden jeder neu angeordneten Zeile auf ein Modulationssymbol der Modulationskonstellation, um eine Vielzahl von Modulationssymbolen zu erlangen;
Übertragen der Vielzahl von Modulationssymbolen in einem Kommunikationssignal (510) an die Empfangsvorrichtung (300).

**5.** Übertragungsvorrichtung (100) nach Anspruch 1, die bei der anfänglichen Übertragung zu Folgendem konfiguriert ist:

Auswählen systematischer Bits jeder Zeile der Matrix, um eine erste Unterzeile für jede Zeile der Matrix zu erlangen, wobei eine erste Unterzeile die systematischen Bits einer Zeile der Matrix umfasst, wobei Bits in der ersten Unterzeile mit einer ersten Zuverlässigkeit auf Modulations-Label-Positionen der Modulationskonstellation abgebildet werden;
Auswählen von Paritätsprüfbits jeder Zeile der Matrix, um eine zweite Unterzeile für jede Zeile der Matrix zu erlangen, wobei eine zweite Unterzeile die Paritätsprüfbits einer Zeile der Matrix umfasst, wobei Bits in der zweiten Unterzeile mit einer zweiten Zuverlässigkeit auf Modulations-Label-Positionen der Modulationskonstellation abgebildet werden.

**6.** Übertragungsvorrichtung (100) nach Anspruch 1, die bei der erneuten Übertragung zu Folgendem konfiguriert ist:

Auswählen von Paritätsprüfbits jeder Zeile der Matrix, um eine erste Unterzeile für jede Zeile der Matrix zu erlangen, wobei eine erste Unterzeile die Paritätsprüfbits einer Zeile der Matrix umfasst, wobei Bits in der ersten Unterzeile mit einer zweiten Zuverlässigkeit auf Modulations-Label-Positionen der Modulationskonstellation abgebildet werden;
Auswählen systematischer Bits jeder Zeile der Matrix, um eine zweite Unterzeile für jede Zeile der Matrix zu erlangen, wobei eine zweite Unterzeile die systematischen Bits einer Zeile der Matrix umfasst, wobei Bits in der zweiten Unterzeile mit einer ersten Zuverlässigkeit auf Modulations-Label-Positionen der Modulationskonstellation abgebildet werden.

**7.** Übertragungsvorrichtung (100) nach Anspruch 5 oder 6, die zu Folgendem konfiguriert ist:

Kombinieren der ersten Unterzeile und der zweiten Unterzeile jeder Zeile in der Matrix, um eine kombinierte Zeile für jede Zeile der Matrix zu erlangen;
Abbilden jeder kombinierten Zeile auf ein Modulationssymbol der Modulationskonstellation, um eine Vielzahl von Modulationssymbolen zu erlangen;
Übertragen der Vielzahl von Modulationssymbolen in einem Kommunikationssignal (510) an die Empfangsvorrichtung (300).

**8.** Übertragungsvorrichtung (100) nach Anspruch 4 oder 7, die zu Folgendem konfiguriert ist:

Bestimmen einer Steuernachricht, wobei die Steuernachricht eine Angabe einer Anzahl von Informationsbits der Informationsnachricht, einer Anzahl codierter Bits des Codeworts und einer Modulationsreihenfolge des Modulationssymbols umfasst;
Übertragen der Steuernachricht an die Empfangsvorrichtung (300).

**9.** Übertragungsvorrichtung (100) nach einem der vorhergehenden Ansprüche, wobei die Modulationskonstellation eine Quadratur-Amplituden-Modulationskonstellation ist.

**10.** Übertragungsvorrichtung (100) nach einem der vorhergehenden Ansprüche, wobei das Codewort zu einem Paritätsprüfungs-Codebuch mit geringer Dichte gehört.

11. Empfangsvorrichtung (300) für ein Kommunikationssystem (500), wobei die Empfangsvorrichtung (300) zu Folgendem konfiguriert ist:

Empfangen eines Kommunikationssignals (520) von einer Übertragungsvorrichtung (100), wobei das Kommunikationssignal (520) eine Vielzahl von Modulationssymbolen umfasst;
Demapping der Vielzahl von Modulationssymbolen, um eine Vielzahl von Soft-Bit-Labels zu erlangen, wobei jedes Soft-Bit-Label der Vielzahl von Soft-Bit-Labels systematische Soft-Bits und Paritätsprüfungs-Soft-Bits umfasst, wobei die Vielzahl von Soft-Bit-Labels zeilenweise in eine Matrix geschrieben werden, beginnend in der oberen linken Ecke und zunächst von links nach rechts und dann von oben nach unten, wobei die Matrix m Spalten und s Zeilen hat, wobei $m$ die Anzahl der Bits in Labels der Modulationskonstellation ist, wobei die systematischen Soft-Bits der Vielzahl von Soft-Bit-Labels von Modulations-Label-Positionen einer Modulationskonstellation mit ersten Zuverlässigkeiten de-mapped werden und die Paritätsprüfungs-Soft-Bits der Vielzahl von Soft-Bit-Labels von Modulations-Label-Positionen einer Modulationskonstellation mit zweiten Zuverlässigkeiten de-mapped werden, wobei bei einem anfänglichen Empfang jede erste Zuverlässigkeit höher ist als jede zweite Zuverlässigkeit und bei einem erneuten Empfang jede erste Zuverlässigkeit niedriger ist als jede zweite Zuverlässigkeit; Entschachteln der Vielzahl von Soft-Bit-Labels, um ein entschachteltes Soft-Codewort zu erlangen, wobei der Inhalt der Matrix spaltenweise zuerst von oben nach unten und dann von links nach rechts gelesen wird; und
Herabstufen des Ratenabgleichs des entschachtelten Soft-Codeworts, um ein herabgestuftes Soft-Codewort zu erlangen.

12. Empfangsvorrichtung (300) nach Anspruch 11, die zu Folgendem konfiguriert ist:
Dekodieren des herabgestuften Soft-Codeworts, um eine Informationsnachricht zu erlangen.

13. Empfangsvorrichtung (300) nach einem der Ansprüche 11 oder 12, die zu Folgendem konfiguriert ist:

Erlangen einer Steuernachricht, wobei die Steuernachricht eine Angabe einer Anzahl von Informationsbits der Informationsnachricht, einer Anzahl codierter Bits des Codeworts und eine Modulationsreihenfolge des Modulationssymbols umfasst;
Entschachteln der Vielzahl von Soft-Labels basierend auf der Steuernachricht.

14. Verfahren für eine Übertragungsvorrichtung (100), wobei das Verfahren (200) Folgendes umfasst:

Erlangen (202) einer Informationsnachricht, die Informationsbits umfasst, die an eine Empfangsvorrichtung (300) adressiert sind;
Kodieren (204) der Informationsnachricht, um ein Codewort zu erlangen;
Ratenabgleichen (206) des Codeworts, um ein ratenabgeglichenes Codewort zu generieren, das systematische Bits und Paritätsprüfbits umfasst;
gemeinsames Verschachteln (208) der systematischen Bits und Paritätsprüfbits des ratenabgeglichenen Codeworts, um ein verschachteltes Codewort zu erlangen, wobei das ratenabgeglichene Codewort durch spaltenweises Schreiben in eine Matrix verschachtelt wird, beginnend in der oberen linken Ecke und fortfahrend zuerst von oben nach unten und dann von links nach rechts, wobei das verschachtelte Codewort eine Matrix mit m Spalten und s Zeilen ist, wobei m die Anzahl der Bits in Labels der Modulationskonstellation ist und wobei s mal m mindestens gleich der Länge des Codeworts ist; und
Abbilden der systematischen Bits des verschachtelten Codeworts auf Modulations-Label-Positionen einer Modulationskonstellation mit ersten Zuverlässigkeiten und Abbilden der Paritätsprüfbits des verschachtelten Codeworts auf Modulations-Label-Positionen der Modulationskonstellation mit zweiten Zuverlässigkeiten, wobei der Inhalt der Matrix zeilenweise gelesen wird, beginnend mit der ersten Zeile, wobei bei einer Erstübertragung jede erste Zuverlässigkeit höher ist als jede zweite Zuverlässigkeit und bei einer erneuten Übertragung jede erste Zuverlässigkeit niedriger ist als jede zweite Zuverlässigkeit.

15. Verfahren für eine Empfangsvorrichtung (300), wobei das Verfahren (400) Folgendes umfasst:

Empfangen (402) eines Kommunikationssignals (520) von einer Übertragungsvorrichtung (100), wobei das Kommunikationssignal (520) eine Vielzahl von Modulationssymbolen umfasst;
Demapping (404) der Vielzahl von Modulationssymbolen, um eine Vielzahl von Soft-Bit-Labels zu erlangen, wobei jedes Soft-Bit-Label der Vielzahl von Soft-Bit-Labels systematische Soft-Bits und Paritätsprüfungs-Soft-Bits umfasst, wobei die Vielzahl von Soft-Bit-Labels zeilenweise in eine Matrix geschrieben ist, beginnend in der oberen linken Ecke und zunächst von links nach rechts und dann von oben nach unten, wobei die Matrix m Spalten und s Zeilen hat, wobei *m* die Anzahl der Bits in Labels der Modulationskonstellation ist, wobei die systematischen Soft-Bits der Vielzahl von Soft-Bit-Labels von Modulations-Label-Positionen einer Modulationskonstellation mit ersten Zuverlässigkeiten de-mapped werden und die Paritätsprüfungs-Soft-Bits der Vielzahl von Soft-Bit-Labels von Modulations-Label-Positionen einer Modulationskonstellation mit zweiten Zuverlässigkeiten de-mapped werden, wobei jede erste Zuverlässigkeit höher ist als jede zweite Zuverlässigkeit bei einem anfänglichen Empfang und jede erste Zuverlässigkeit niedriger ist als jede zweite Zuverlässigkeit bei einem erneuten Empfang;

Entschachteln (406) der Vielzahl von Soft-Bit-Labels, um ein entschachteltes Soft-Codewort zu erlangen, wobei der Inhalt der Matrix spaltenweise zuerst von oben nach unten und dann von links nach rechts gelesen wird; und Herabstufen des Ratenabgleichs (408) des entschachtelten Soft-Codeworts, um ein herabgestuftes Soft-Codewort zu erlangen.

**16.** Computerprogramm mit einem Programmcode zum Durchführen des Verfahrens nach Anspruch 14 oder 15, wenn das Computerprogramm auf einem Computer ausgeführt wird.

## Revendications

**1.** Appareil de transmission (100) pour un système de communication (500), l'appareil de transmission (100) étant configuré pour

obtenir un message d'information comprenant des bits d'information destinés à un appareil de réception (300) ; coder le message d'information de manière à obtenir un mot de code ;

adapter le mot de code en débit de manière à produire un mot de code adapté en débit comprenant des bits systématiques et des bits de contrôle de parité ;

entrelacer conjointement les bits systématiques et les bits de contrôle de parité du mot de code adapté en débit de manière à obtenir un mot de code entrelacé, le mot de code adapté en débit étant entrelacé en l'écrivant par colonne dans une matrice, en partant du coin supérieur gauche et en procédant de haut en bas en premier puis de gauche à droite, le mot de code entrelacé étant une matrice comprenant m colonnes et s rangées, m étant le nombre de bits dans les étiquettes de la constellation de modulation, et s fois *m* étant au moins égal à la longueur du mot de code ; et

binariser les bits systématiques du mot de code entrelacé à des positions d'étiquette de modulation d'une constellation de modulation avec une première fiabilité, et binariser les bits de contrôle de parité du mot de code entrelacé à des positions d'étiquette de modulation de la constellation de modulation avec une seconde fiabilité, dans lequel le contenu de la matrice étant lu par rangée, à partir de la première rangée, chaque première fiabilité étant supérieure à toute seconde fiabilité lors d'une transmission initiale, et chaque première fiabilité étant inférieure à toute seconde fiabilité lors d'une retransmission.

**2.** Appareil de transmission (100) selon la revendication 1, configuré pour, lors de la transmission initiale, décaler circulairement chaque rangée de la matrice de manière à obtenir une rangée réarrangée pour chaque rangée de la matrice, dans lequel les bits systématiques d'une rangée de la matrice sont disposés dans les positions extrêmes gauches d'une rangée réarrangée et les bits de contrôle de parité de la rangée de la matrice sont disposés dans les positions extrêmes droites de la rangée réarrangée, dans lequel les bits dans les positions extrêmes gauches de la rangée réarrangée sont binarisés à des positions d'étiquette de modulation de la constellation de modulation avec une première fiabilité et les bits dans les positions extrêmes droites de la rangée réarrangée sont binarisés à des positions d'étiquette de modulation de la constellation de modulation avec une seconde fiabilité.

**3.** Appareil de transmission (100) selon la revendication 1, configuré pour, lors de la retransmission, décaler circulairement chaque rangée de la matrice de manière à obtenir une rangée réarrangée pour chaque rangée de la matrice, les bits systématiques d'une rangée de la matrice étant disposés dans les positions extrêmes droites d'une rangée réarrangée et les bits de contrôle de parité de la rangée de la matrice étant disposés dans les positions extrêmes gauches de la rangée réarrangée, les bits dans les positions extrêmes gauches de la rangée réarrangée étant binarisés à des positions d'étiquette de modulation de la constellation de modulation avec une seconde fiabilité et les bits dans les positions extrêmes droites de la rangée réarrangée étant binarisés à des positions d'étiquette de modulation de la constellation de modulation avec une première fiabilité.

**4.** Appareil de transmission (100) selon la revendication 2 ou 3, configuré pour

binariser chaque rangée réarrangée sur un symbole de modulation de la constellation de modulation de manière à obtenir une pluralité de symboles de modulation ;
transmettre la pluralité de symboles de modulation dans un signal de communication (510) vers l'appareil de réception (300) .

**5.** Appareil de transmission (100) selon la revendication 1, configuré pour, lors de la transmission initiale,

sélectionner des bits systématiques de chaque rangée de la matrice de manière à obtenir une première sous-rangée pour chaque rangée de la matrice, une première sous-rangée comprenant les bits systématiques d'une rangée de la matrice, les bits de la première sous-rangée étant binarisés à une première fiabilité avec des positions d'étiquette de modulation de la constellation de modulation ;
sélectionner des bits de contrôle de parité de chaque rangée de la matrice de manière à obtenir une seconde sous-rangée pour chaque rangée de la matrice, une seconde sous-rangée comprenant les bits de contrôle de parité d'une rangée de la matrice, les bits de la seconde sous-rangée étant binarisés à des positions d'étiquette de modulation de la constellation de modulation avec une seconde fiabilité.

**6.** Appareil de transmission (100) selon la revendication 1, configuré pour, lors de la retransmission,

sélectionner des bits de contrôle de parité de chaque rangée de la matrice de manière à obtenir une première sous-rangée pour chaque rangée de la matrice, une première sous-rangée comprenant les bits de contrôle de parité d'une rangée de la matrice, les bits de la première sous-rangée étant binarisés à des positions d'étiquette de modulation de la constellation de modulation avec une seconde fiabilité ;
sélectionner des bits systématiques de chaque rangée de la matrice de manière à obtenir une seconde sous-rangée pour chaque rangée de la matrice, une seconde sous-rangée comprenant les bits systématiques d'une rangée de la matrice, les bits de la seconde sous-rangée étant binarisés à des positions d'étiquette de modulation de la constellation de modulation avec une première fiabilité.

**7.** Appareil de transmission (100) selon la revendication 5 ou 6, configuré pour

combiner la première sous-rangée et la seconde sous-rangée de chaque rangée de la matrice de manière à obtenir une rangée combinée pour chaque rangée de la matrice ;
binariser chaque rangée combinée à un symbole de modulation de la constellation de modulation de manière à obtenir une pluralité de symboles de modulation ;
transmettre la pluralité de symboles de modulation dans un signal de communication (510) vers l'appareil de réception (300) .

**8.** Appareil de transmission (100) selon la revendication 4 ou 7, configuré pour

déterminer un message de commande, le message de commande comprenant une indication d'un nombre de bits d'information du message d'information, d'un nombre de bits codés du mot de code, et d'un ordre de modulation du symbole de modulation ;
transmettre le message de commande vers l'appareil de réception (300) .

**9.** Appareil de transmission (100) selon l'une quelconque des revendications précédentes, dans lequel la constellation de modulation est une constellation de modulation d'amplitude en quadrature.

**10.** Appareil de transmission (100) selon l'une quelconque des revendications précédentes, dans lequel le mot de code appartient à un livre de codes à contrôle de parité à faible densité.

**11.** Appareil de réception (300) pour un système de communication (500), l'appareil de réception (300) étant configuré pour

recevoir un signal de communication (520) d'un appareil de transmission (100), le signal de communication (520) comprenant une pluralité de symboles de modulation ;
débinariser la pluralité de symboles de modulation de manière à obtenir une pluralité d'étiquettes de bits programmables, chaque étiquette de bits programmables de la pluralité d'étiquettes de bits programmables comprenant des bits programmables systématiques et des bits programmables de contrôle de parité, la pluralité d'étiquettes de bits programmables étant écrites par rangée dans une matrice, en partant du coin supérieur gauche et en procédant de gauche à droite en premier, puis de haut en bas, dans lequel la matrice comprend m colonnes et s rangées, dans lequel m est le nombre de bits dans les étiquettes de la constellation de modulation, dans lequel les bits programmables systématiques de la pluralité d'étiquettes de bits programmables sont débinarisés des positions d'étiquettes de modulation d'une constellation de modulation avec une première fiabilité et les bits programmables de contrôle de parité de la pluralité d'étiquettes de bits programmables sont débinarisés des positions d'étiquettes de modulation de la constellation de modulation avec une seconde fiabilité, dans lequel chaque première fiabilité est supérieure à toute seconde fiabilité lors d'une réception initiale, et chaque première fiabilité est inférieure à toute seconde fiabilité lors d'une réception ultérieure ;
désentrelacer la pluralité d'étiquettes de bits programmables de manière à obtenir un mot de code programmable désentrelacé, le contenu de la matrice étant lu par colonne de haut en bas en premier, puis de gauche à droite ; et
désadapter le mot de code programmable désentrelacé en débit de manière à obtenir un mot de code programmable désadapté en débit.

**12.** Appareil de réception (300) selon la revendication 11, configuré pour
décoder le mot de code programmable désadapté en débit afin d'obtenir un message d'information.

**13.** Appareil de réception (300) selon l'une quelconque des revendications 11 ou 12, configuré pour

obtenir un message de commande, le message de commande comprenant une indication d'un nombre de bits d'information du message d'information, d'un nombre de bits codés du mot de code, et d'un ordre de modulation du symbole de modulation ;
désentrelacer la pluralité d'étiquettes programmables en fonction du message de commande.

**14.** Procédé d'un appareil de transmission (100), le procédé (200) comprenant

l'obtention (202) d'un message d'information comprenant des bits d'information destinés à un appareil de réception (300) ;
le codage (204) du message d'information de manière à obtenir un mot de code ;
l'adaptation en débit (206) du mot de code de manière à produire un mot de code adapté en débit comprenant des bits systématiques et des bits de contrôle de parité ;
l'entrelacement conjoint (208) des bits systématiques et des bits de contrôle de parité du mot de code adapté en débit de manière à obtenir un mot de code entrelacé, le mot de code adapté en débit étant entrelacé en l'écrivant par colonne dans une matrice, en partant du coin supérieur gauche et en procédant de haut en bas d'abord, puis de gauche à droite, le mot de code entrelacé étant une matrice comprenant m colonnes et s rangées, m étant le nombre de bits dans les étiquettes de la constellation de modulation, et s fois $m$ étant au moins égal du mot de code ; et
la binarisation des bits systématiques du mot de code entrelacé avec des positions d'étiquette de modulation d'une constellation de modulation avec une première fiabilité, et la binarisation des bits de contrôle de parité du mot de code entrelacé avec des positions d'étiquette de modulation de la constellation de modulation avec une seconde fiabilité, le contenu de la matrice étant lu rangée par rangée, à partir de la première rangée, chaque première fiabilité étant supérieure à toute seconde fiabilité lors d'une transmission initiale, et chaque première fiabilité étant inférieure à toute seconde fiabilité lors d'une retransmission.

**15.** Procédé d'un appareil de réception (300), le procédé (400) comprenant

la réception (402) d'un signal de communication (520) provenant d'un appareil de transmission (100), dans lequel le signal de communication (520) comprend une pluralité de symboles de modulation ;
la débinarisation (404) de la pluralité de symboles de modulation de manière à obtenir une pluralité d'étiquettes de bits programmables, chaque étiquette de bits programmables de la pluralité d'étiquettes de bits programmables comprenant des bits programmables systématiques et des bits programmables de contrôle de parité, dans lequel la pluralité d'étiquettes de bits programmables est écrites par rangée dans une matrice, en commençant par le coin supérieur gauche et en procédant de gauche à droite en premier, puis de haut en bas, la matrice comprenant m colonnes et s rangées, m étant le nombre de bits dans les étiquettes de la constellation de modulation, les bits programmables systématiques de la pluralité d'étiquettes de bits programmables étant débinarisés des positions d'étiquettes de modulation de la constellation de modulation avec une première fiabilité et les bits programmables de contrôle de parité de la pluralité d'étiquettes de bits programmables sont débinarisés des positions d'étiquettes de modulation de la constellation de modulation avec une seconde fiabilité, chaque première fiabilité étant supérieure à toute seconde fiabilité lors d'une réception initiale, et chaque première fiabilité étant inférieure à toute seconde fiabilité lors d'une réception ultérieure ;

le désentrelacement (406) de la pluralité d'étiquettes de bits programmables de manière à obtenir un mot de code programmable désentrelacé, le contenu de la matrice étant lu par colonne de haut en bas en premier, puis de gauche à droite ; et

le désentrelacement (408) du mot de code programmable désentrelacé de manière à obtenir un mot de code programmable désentrelacé.

16. Programme d'ordinateur avec un code de programme pour mettre en œuvre un procédé selon la revendication 14 ou 15 lorsque le programme d'ordinateur s'exécute sur un ordinateur.

500

[510]

100

i → 102 → 104 →c 106 →B 108 →x

110

[510]

112

Fig. 1

500

[520]

310

300

r → 302 →l 304 →B⁻¹ 306 → 308 →î

[520]

312

Fig. 2

Fig. 3

Fig. 4

Fig. 5

200

Fig. 6

400

Fig. 7

Fig. 8

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2003081690 A1

**Non-patent literature cited in the description**

- **MEDIATEK INC.** On design of bit-level interleaver. *3GPP draft,* 20 August 2017, vol. RAN WG1
- Text proposal for SMP (Symbol Mapping based on bit Priority). *TSG-RAN WORKING GROUP 1 MEETING,* 08 January 2002
- **SAMSUNG.** Bit-level interleaver of LDPC codes on high order modulation. *3GPP draft,* 26 August 2017, vol. RAN WG1
- **QUALCOMM INCORPORATED.** LDPC Rate Matching. *3GPP DRAFT,* 26 June 2017, vol. RAN WG1
- **SAFAVI ANAHID R et al.** Ultra Low Density Spread Transmission. IEEE, 01 July 2016, vol. 20, 1373-1376
- **ZAIDI ALI et al.** ERICSSON TECHNOLOGY 5G NEW RADIO: DESIGNING FOR THE FUTURE * 5G NR PHYSICAL LAYER DESIGN 2 ERICSSON TECHNOLOGY REVIEW. *ERICSSON TECHNOLOGY REVIEW ARTICLES,* 24 July 2017